# EUROPEAN PATENT SPECIFICATION

(11) **EP 1 701 176 B1**
(45) Date of publication and mention of the grant of the patent: **11.06.2014**
(21) Application number: 05710550.4
(22) Date of filing: 23.02.2005
(51) Int. Cl.: G01R 33/09, G01D 5/00, G07D 7/04

(54) **PROLONGED MAGNETIC SENSOR**
AUSGEDEHNTER MAGNETFELDSENSOR
CAPTEUR MAGNETIQUE ALLONGE

(30) Priority: 27.02.2004 JP 2004054767
(43) Date of publication of application: 13.09.2006
(73) Proprietor: MURATA MANUFACTURING CO., LTD., Nagaokakyo-shi, Kyoto 617-8555 (JP)
(72) Inventor: MINAMITANI, Tamotsu, Murata Manufacturing Co.,Ltd., Nagaokakyo-shi, Kyoto 617-8555 (JP); SHINMURA, Koji, Murata Manufacturing Co., Ltd., Nagaokakyo-shi, Kyoto 617-8555 (JP); UEDA, Masaya, Murata Manufacturing Co., Ltd., Nagaokakyo-shi, Kyoto 617-8555 (JP); NISHIKAWA, Masanaga, Murata Manufacturing Co.,Ltd., Nagaokakyo-shi, Kyoto 617-8555 (JP)
(74) Representative: Stöckeler, Ferdinand
(86) International application number: PCT/JP2005/002854
(87) International publication number: WO 2005/083457

(56) References cited:
- JP-A- 5 332 703
- JP-A- 61 039 592
- US-A- 5 041 785
- US-A- 5 841 275

## Description

### Technical Field

The present invention relates to a long magnetic sensor for detecting a magnetic pattern which is printed on, for instance, a paper money.

### Background Art

Magnetic sensors for distinguishing paper moneys, securities, or the like on which predetermined patterns are printed by using magnetic inks are disclosed in Patent Documents 1 and 2. A configuration of the long magnetic sensor disclosed in Patent Document 1 is shown in Fig. 8. Part (A) in the same drawing is a plan view showing magnetosensitive portions with a cover being removed. In this example, magnetic resistance elements (MR elements) 2a to 2e are provided with pairs of magnetosensitive portions 20a to 20e, respectively. The magnetic resistance elements 2a to 2e are aligned and fixed in a case 1. A detection object is carried in a direction orthogonal to the longitudinal direction of such a long magnetic sensor 200.

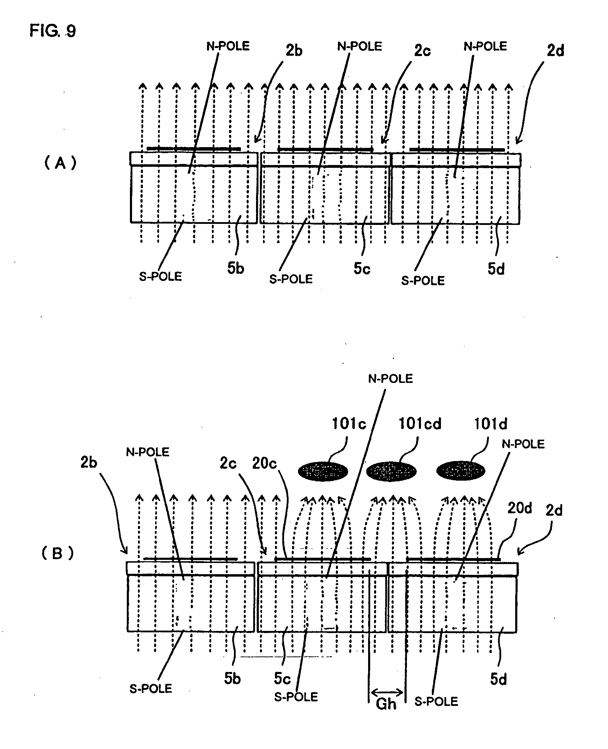

Fig. 9 is a front elevational view showing a structure of the lower portions of the magnetic resistance elements, and the state of magnetic fields which are applied to the magnetic resistance elements. Note that only three magnetic resistance elements 2b to 2d are shown here. Magnets 5b to 5d are disposed at the lower portions of the magnetic resistance elements 2b to 2d so that magnetic fluxes pass through the magnetic resistance elements 2b to 2d perpendicularly.

Part (B) of Fig. 9 shows the state where magnetic substances (magnetic inks) 101c, 101cd, and 101d of the detection object reach the vicinity of the long magnetic sensor. The magnetic substances 101c, 101cd, and 101d reach there sequentially with a time-lag. When the magnetic substances 101c, 101cd, and 101d are present within the magnetic fields due to the magnets 5c and 5d, concentration of the magnetic fluxes is induced to the magnetic substances, and also the magnetic flux density of the magnetic fluxes passing through the magnetosensitive portions 20c and 20d are increased. This causes increase in resistances of the magnetic resistance elements, and thus the presence of the magnetic substances 101c, 101cd, and 101d is detected.

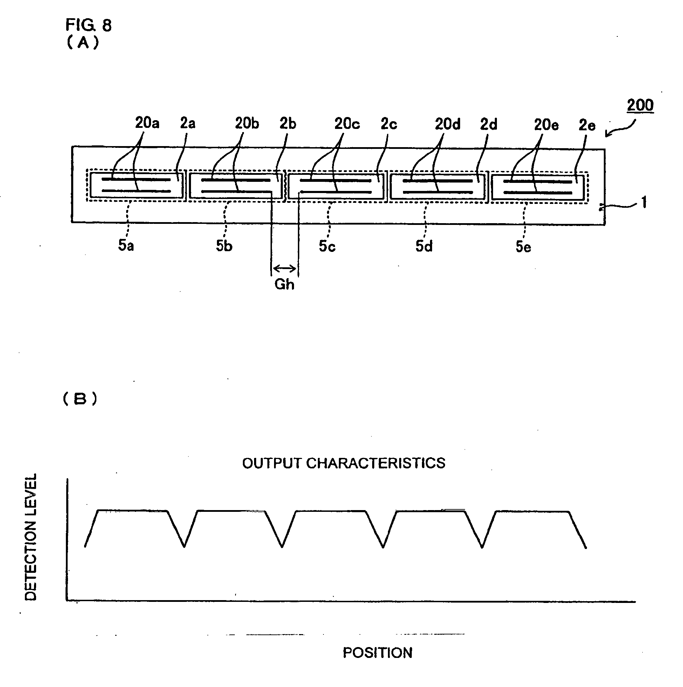

However, many of the magnetic fluxes headed toward the magnetic substance 101cd, which are located at the center portions of the two adjacent magnetosensitive portions 20c and 20d, do not pass through the magnetosensitive portions 20c and 20d, but pass through a gap Gh formed therebetween. Since change in the magnetic flux density of the magnetic fluxes passing through the gap Gh does not make an effect on a magnetic resistance effect due to the magnetosensitive portions 20c and 20d, a detection level (detection capability) in the vicinity of the gap Gh may be degraded. Part (B) of Fig. 8 shows exemplary characteristics of the detection level with respect to positions in the longitudinal direction of the long magnetic sensor.
Patent Document 1: Japanese Patent No. 2921262
Patent Document 2: Japanese Unexamined Patent Application Publication No. 2003-107142

### Disclosure of Invention

### Problems to be Solved by the Invention

However, the long magnetic sensor including the position where the detection level is degraded as shown in part (B) of Fig. 8 is inappropriate when it is necessary to detect the magnetic substance pattern extending over the detection object. To solve this, as disclosed in Patent Document 2, there is a configuration in which magnets and magnetic resistance elements are disposed in a zigzag manner, respectively, in a plane parallel to the magnetosensitive portions of the magnetic resistance elements.

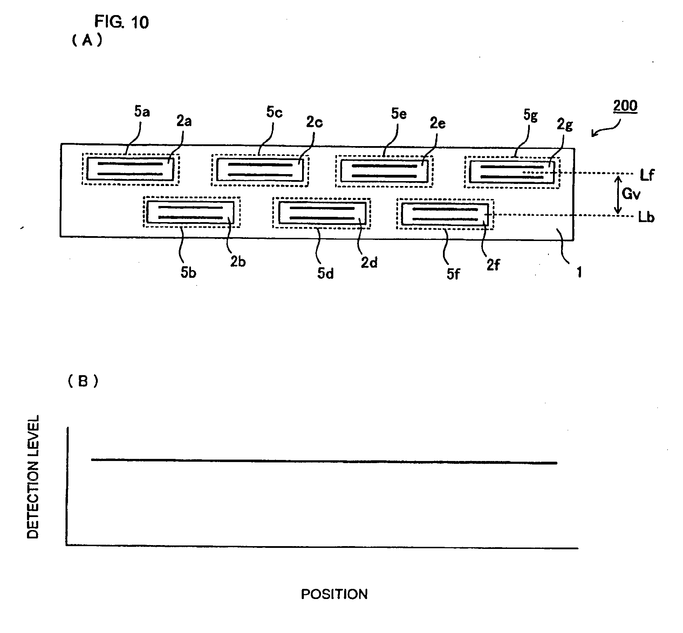

Fig. 10 shows a configuration of such a long magnetic sensor. Part (A) in the same drawing is a plan view showing the magnetosensitive portions with the cover being removed. In this example, the magnetic resistance elements 2a to 2g are disposed in the case 1 in a staggered manner in a plane parallel to the magnetosensitive portions. A detection object is carried in a direction orthogonal to the longitudinal direction of the long magnetic sensor 200.

As described above, the arrangement of the plurality of magnetic resistance elements 2a to 2g in a zigzag manner can ensure a substantially uniform detection level over the longitudinal direction of the long magnetic sensor as shown in the exemplary characteristics shown in part (B) of Fig. 10.

However, as shown in Fig. 10, in the long magnetic sensor in which the magnetic resistance elements are disposed in a zigzag manner in a plane parallel to the magnetosensitive portions, the positions of the two adjacent magnetic resistance elements may be deviated from each other by a gap Gv in a moving direction of the detection object. Accordingly, an extra signal processing or data processing is required for correcting a time-lag corresponding to the positional deviation of Gv. In addition, since a correction amount of the positional deviation between the adjacent magnetic resistance elements may be different from that between other adjacent magnetic resistance elements depend on the accuracy of the moving speed of the detection object, it is difficult to provide a uniform output.

Further, while the detection object is carried between the case of the long magnetic sensor and a conveying roller, if a distance between the magnetosensitive portions and the detection object is varied in a path between lines Lf and Lb as shown in Fig. 10, the detection level may also be varied. Accordingly, it is also troublesome and difficult to properly adjust the distance between the conveying roller and the long magnetic sensor.

Therefore, the present invention provides a long magnetic sensor which addresses the above-described problems while no gap is substantially provided at any detection position in the longitudinal direction or in a direction orthogonal thereto (moving direction of an detection object).

### Means for Solving the Problems

To achieve this, a long magnetic sensor is configured as follows.
(1) A long magnetic sensor includes: a plurality of magnetic resistance elements which are provided with magnetosensitive portions on surfaces or in the vicinities of the surfaces, a longitudinal direction of each of the magnetosensitive portions being substantially orthogonal to a moving direction of a detection object; and a plurality of magnets for applying magnetic fields to the magnetosensitive portions of the magnetic resistance elements, in which the magnetosensitive portions of the plurality of magnetic resistance elements and the plurality of magnets are aligned substantially linearly to be orthogonal to the moving direction of the detection object, and the magnets are disposed so that directions of magnetic fluxes, which are substantially perpendicular to the surfaces with the magnetosensitive portions of the magnetic resistance elements provided, of the adjacent magnets are inverse to each other.
(2) According to (1), the magnets are disposed in one-to-one correspondence with the magnetic resistance elements.
(3) According to (1), each of the magnetic resistance elements is disposed so that at least two of the plurality of magnets make a unit in the order of arrangement of the magnets and the magnetic resistance element entirely spans at least the two magnets.
(4) According to (1), each of the magnetic resistance elements is disposed to span the adjacent magnets at each of positions where the plurality of magnets are adjacent to each other.
(5) According to (1) through (4), frames are provided in a case for housing the magnets so that the magnets are disposed along an alignment direction of the magnetic resistance elements in a zigzag manner in a plane parallel to the magnetosensitive portions of the magnetic resistance elements.

### Advantages

(1) Since directions of the magnetic poles of the adjacent magnets which apply magnetic fields to the magnetic resistance elements are inverse to each other, when considering the two adjacent magnetic resistance elements, the magnetic fields are distributed so that the lines of magnetic force upwardly come out from the lower portion of the magnetic resistance element, downwardly come into the lower portion of the magnetosensitive portion of the other magnetic resistance element adjacent to the former. Accordingly, when the magnetic substance of the detection object reaches the position between the two adjacent magnetic resistance elements, the magnetic flux density of the magnetic fluxes passing through the magnetosensitive portions of the two magnetic resistance elements are changed, thereby enabling the detection of the magnetic substance. In addition, since the positions of the plurality of magnetic resistance elements of the long magnetic sensor are linearly disposed, at the time of attaching the long magnetic sensor to a device, a diameter of a roller for carrying the detection object, and a distance therebetween can be easily adjusted. Further, since the magnetic poles of the adjacent magnets are heteropolar, the magnets are attracted to each other but not repelled from each other. Accordingly, the magnets easily can be housed in magnet housings of the case.
(2) Since the magnets are disposed in one-to-one correspondence with the magnetic resistance elements, the magnetic flux perpendicularly passes through each magnetosensitive portion at the center portion of the magnetosensitive portion of the magnetic resistance element, similarly to the conventional art. Accordingly, the detection characteristics similar to that of the conventional art can be obtained at the center portion of the magnetosensitive portion.
(3) Since each of the magnetic resistance elements is disposed so that at least two of the plurality of magnets make a unit in the order of arrangement of the magnets, and the magnetic resistance element entirely spans at least the two magnets, the number of the magnets is increased (at least twice) with respect to that of the magnetic resistance elements, and coming in/out positions of the lines of magnetic force are arranged at a narrow pitch in a direction toward the detection object. Accordingly, an ability to compensate the degradation of the output can be enhanced at the end portions of the magnetosensitive portion of the magnetic resistance element, and the output characteristics similar to that of the conventional art can be provided at the center portion of the magnetosensitive portion.
(4) Since each of the magnetic resistance elements is disposed to span the adjacent magnets at each of positions where the plurality of magnets are adjacent to each other, the center portion of the magnet would be located between the two magnetic resistance elements adjacent to each other. Generally, the magnetic flux density of the center portion of the magnet is high and stable as compared to the end portions thereof, the degradation of the detection level between the magnetic resistance elements can be compensated, thereby providing the detection level characteristics which show a flat line over the longitudinal direction. In addition, even when the positions of the borders of the adjacent magnets are unevenly disposed, the variation in the detection level due to the unevenness can be reduced.
(5) Since the frames are provided in the case so that the magnets are disposed along the alignment direction of the magnetic resistance elements in a zigizag manner in a plane parallel to the magnetosensitive portions of the magnetic resistance elements, in view of designing the case structure for housing the magnetic resistance elements and the magnets, the positions of the magnets relative to the case can be accurately determined, and consequently the long magnetic sensor with the attachment accuracy being improved and the characteristics thereof being uniform can be stably produced.

### Brief Description of the Drawings

Fig. 1 is an external perspective view showing a long magnetic sensor according to a first embodiment.
Fig. 2 illustrates a positional relationship between magnetic resistance elements and magnets of the long magnetic sensor; and detection level characteristics with respect to positions in the longitudinal direction.
Fig. 3 illustrates a magnetic flux density distribution due to the magnet of the long magnetic sensor; and change in magnetic flux density on account of the presence of a magnetic substance.
Fig. 4 illustrates an example of a positional relationship between the adjacent magnetic resistance elements; and another example of that between the adjacent magnets.
Fig. 5 illustrates a positional relationship between magnetic resistance elements and magnets of a long magnetic sensor according to a second embodiment.
Fig. 6 illustrates a positional relationship between magnetic resistance elements and magnets of a long magnetic sensor according to a third embodiment.
Fig. 7 illustrates a positional relationship between magnetic resistance elements with respect to a case, of a long magnetic sensor according to a fourth embodiment.
Fig. 8 illustrates a configuration of a long magnetic sensor disclosed in Patent Document 1.
Fig. 9 illustrates an example of a magnetic flux density distribution of the long magnetic sensor.
Fig. 10 illustrates a configuration of a long magnetic sensor disclosed in Patent Document 2.

### Reference Numerals

- 1: case
- 2: magnetic resistance element
- 3: claw-engaging groove
- 4: cover
- 5: magnet
- 6: terminal pin
- 10: frame
- 11: cover terminal
- 20: magnetosensitive portion
- 100: detection object
- 101: magnetic substance (magnetic ink)
- 200: long magnetic sensor

### Best Mode for Carrying Out the Invention

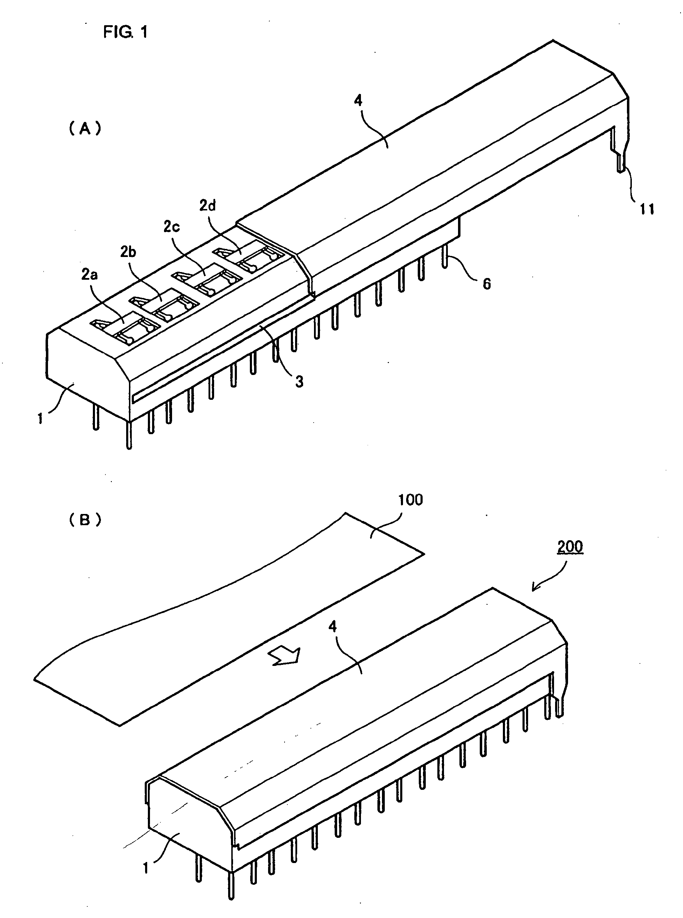

A configuration of a long magnetic sensor according to a first embodiment will be described below with reference to Figs. 1 to 4.

Fig. 1 is an external perspective view showing a long magnetic sensor, in which part (A) shows the state in the middle of attaching a cover, and part (B) shows the state with the cover attached. Magnetic resistance elements 2a, 2b, 2c, 2d ... are mounted on the upper portion of a case 1 made of synthetic resin. Terminal pins 6 which are connected to the plurality of magnetic resistance elements 2a, 2b, 2c, 2d ... project at the lower portion of the case 1. Claw-engaging grooves 3 are provided on both lateral sides of the case 1 along the longitudinal direction.

A metal cover 4 is provided with cover-fixing claws which are engaged with the claw-engaging grooves 3 of the case. When the cover 4 slides in the longitudinal direction while both the claw-engaging grooves 3 and the cover-fixing claws are engaged with each other, the cover 4 covers the upper portion of the case 1 as shown in part (B) of Fig. 1. A detection object 100 is carried in a direction substantially orthogonal to the longitudinal direction of the long magnetic sensor 200 as shown by an arrow in the drawing.

The cover 4 is provided with a cover terminal 11 to be electrically ground connected to a circuit board.

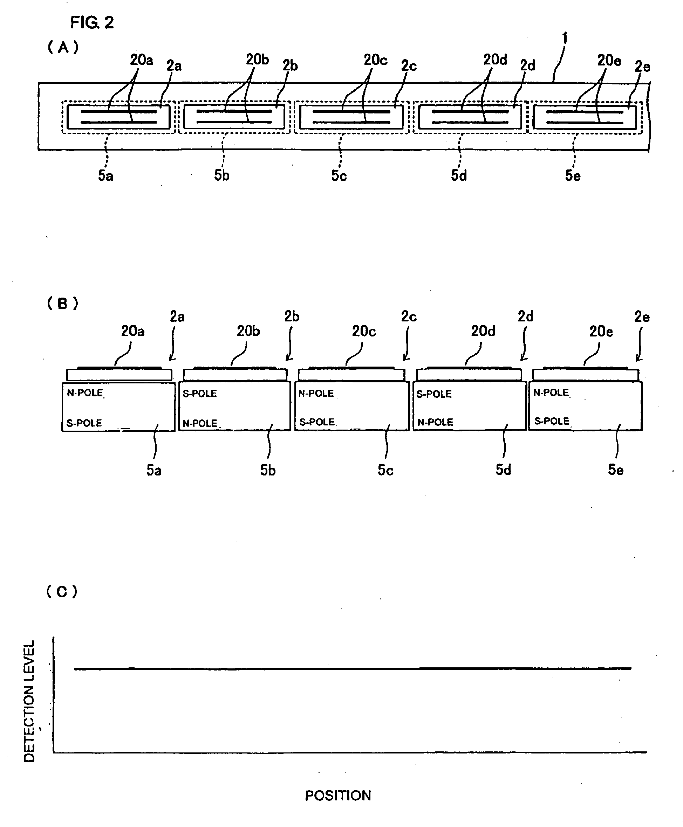

Part (A) of Fig. 2 is a plan view showing the state with the cover removed from the long magnetic sensor shown in Fig. 1. Part (B) is a cross-sectional view taken along a plane perpendicular to the surface with magnetosensitive portions formed, and passing through the plurality of magnetic resistance elements and the plurality of magnets. Note that here only shows the magnetic resistance elements 2a to 2e. In addition, in part (B), the illustration of the case 1 is omitted.

Magnets 5a to 5e are provided at the lower portions of the magnetic resistance elements 2a to 2e, respectively. Magnetosensitive portions 20a to 20e are formed at the magnetic resistance elements 2a to 2e, respectively. When the detection object 100 shown in Fig. 1 is a sheet of paper like a paper money, while the object may not be always carried in a direction exactly orthogonal to the longitudinal direction of the long magnetic sensor 200, the magnetosensitive portions 20a to 20e are formed on the surfaces or in the vicinities of the surfaces of the magnetic resistance elements 2a to 2e so that the longitudinal direction of the magnetosensitive portions 20a to 20e are substantially orthogonal to the moving direction of the detection object.

Directions of magnetic poles (N-pole and S-pole) of the magnets 5a to 5e are disposed so that the magnetic fluxes perpendicularly pass through the magnetic resistance elements 2a to 2e, and the directions of the magnetic poles of the adjacent magnet are inverse to each other. That is, the N-pole of the magnet 5a faces the magnetic resistance element 2a, while the S-pole of the magnet 5b which is adjacent to the magnet 5a faces the magnetic resistance element 2b. Then the N-pole of the magnet 5c which is adjacent to the magnet 5b faces the magnetic resistance element 2c. Similarly to the above-described arrangement, the direction of the magnetic poles of the adjacent magnets are inverse to each other.

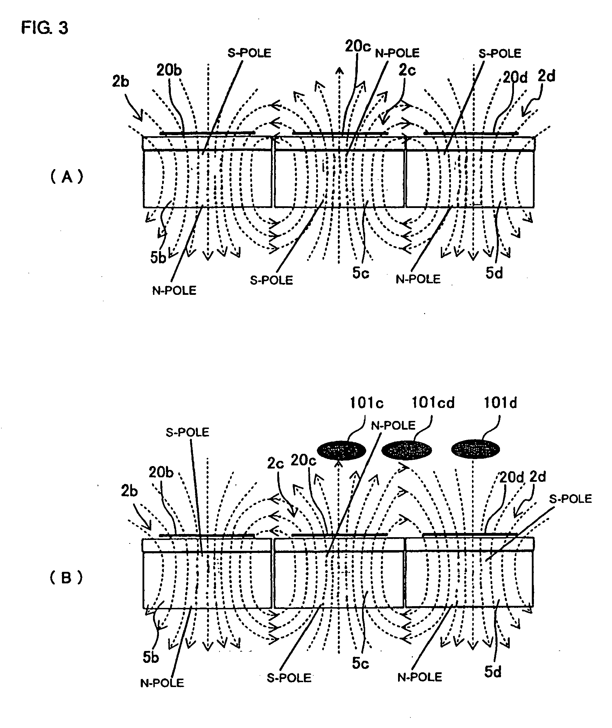

Fig. 3 is an example of a magnetic field distribution when the directions of the magnetic poles of the magnets are disposed as shown in part (A) of Fig. 2. As shown in part (A) of Fig. 3, lines of magnetic force coming out from the N-pole of the magnet 5c upwardly pass through the magnetosensitive portion 20c of the magnetic resistance element 2c. Then the lines of magnetic force downwardly pass through the magnetosensitive portions 20b and 20d of the magnetic resistance elements 2b and 2d, and then come into the S-poles of the magnets 5b and 5d. At this time, the lines of magnetic force of the magnetic flux coming out from the N-pole of the magnet 5c are curved in a loop form and then come into the S-poles of the adjacent magnets 5b and 5d.

As shown in part (B) of Fig. 3, when the magnetic substances 101c, 101cd and 101d of the detection object reach the vicinities of the magnetic resistance elements 2c and 2d, and the magnetosensitive portions 20c and 20d, sequentially with a time-lag, the magnetic flux being headed to the magnet 5d from the magnet 5c is attracted by the magnetic substance 101cd, passes through the magnetosensitive portions 20c and 20d of the magnetic resistance elements 2c and 2d nearly perpendicularly, and the magnetic flux density thereof is increased. Consequently, the presence of the magnetic substance 101cd can be detected due to the change in resistances of the magnetic resistance elements 2c and 2d. In addition, since the magnetic flux density of the magnetic flux passing through the magnetosensitive portion 20c of the magnetic resistance element 2c is increased because of the presence of the magnetic substance 101c, it can be detected that the magnetic substance 101c has reached there due to the change in the resistance of the magnetic resistance element 2c. Similarly, since the magnetic flux density of the magnetic flux passing through the magnetosensitive portion 20d of the magnetic resistance element 2d is increased because of the presence of the magnetic substance 101d, it can be detected that the magnetic substance 101d has reached there due to the change in the resistance of the magnetic resistance element 2d.

Part (C) of Fig. 2 shows exemplary characteristics of the detection level with respect to positions of the long magnetic sensors in the longitudinal direction. When the magnetic resistance element is viewed in a plane parallel to the magnetosensitive portion, since the magnetic substance can be detected even at a position where the magnetosensitive portion is not provided, as shown in the drawing, the detection level would not be degraded at any position in the longitudinal direction of the long magnetic sensor and can provide a substantially uniform detection level.

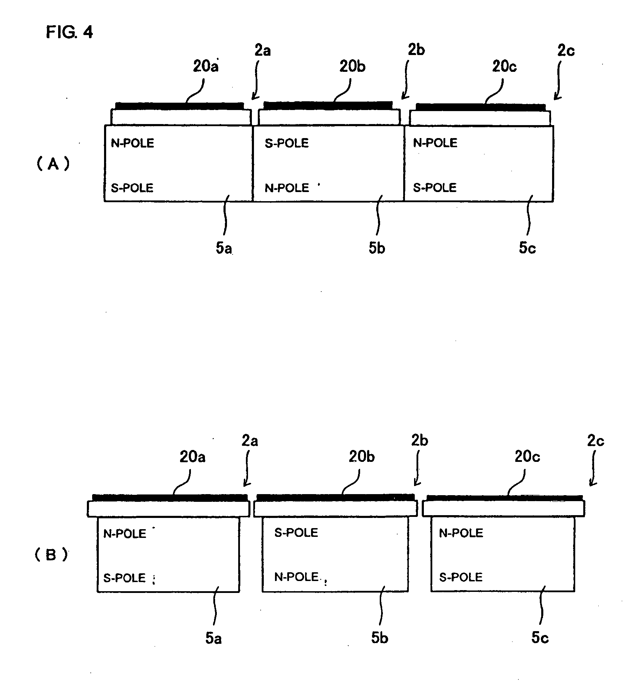

In the examples as shown in Figs. 2 and 3, while small gaps are provided between the adjacent magnets and between the adjacent magnetic resistance elements, for instance, the continuously disposed magnets 5a, 5b and 5c can be closely attached as shown in part (A) of Fig. 4. Alternatively, as shown in part (B) of the same drawing, the gap among the continuously disposed magnets 5a, 5b and 5c can be different from that of the continuously disposed magnetic resistance elements 2a, 2b and 2c, namely, the gap among the magnets 5a, 5b and 5c can be larger than that among the magnetosensitive portions 20a, 20b and 20c of the magnetic resistance elements 2a, 2b and 2c.

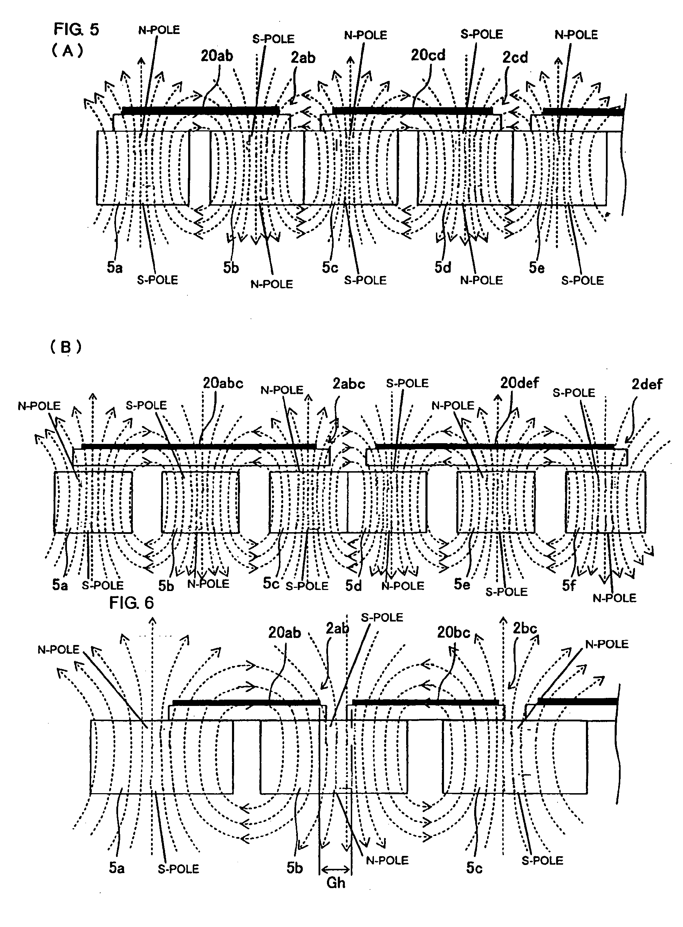

Next, a long magnetic sensor according to a second embodiment will be described below with reference to Fig. 5.

As shown in an example in part (A) of Fig. 5, the magnetic resistance element is disposed so that two of the plurality of magnets make a unit in the order of arrangement and the magnetic resistance element spans the two magnets. Particularly, a magnetic resistance element 2ab is disposed to span the magnets 5a and 5b. In addition, a magnetic resistance element 2cd is disposed to span the magnets 5c and 5d.

With this structure, the magnetic flux coming out from the magnet 5a comes into the adjacent magnet 5b. The magnetic flux coming out from the magnet 5a passes through the left portion of the magnetosensitive portion 20ab, then passes through the right portion thereof, and then comes into the magnet 5b. Similarly, the magnetic flux coming out from the magnet 5c passes through the left portion of a magnetosensitive portion 20cd, then passes through the right portion thereof, and then comes into the magnet 5d. Further, the magnetic flux coming out from the magnet 5c passes through the left portion of the magnetosensitive portion 20cd, then passes through the right portion of the magnetosensitive portion 20ab, and then comes into the magnet 5b.

Accordingly, when viewed in a plane parallel to the magnetosensitive portion, if the magnetic substance of the detection object is present at the center portion of the magnetosensitive portion 20ab, 20cd or the like, the presence of the magnetic substance can be detected due to the change in the resistance of the magnetic resistance element provided with the magnetosensitive portion. In addition, if the magnetic substances is present at a position where the magnetosensitive portion is not provided, like a position between the magnetosensitive portions 20ab and 20cd, similarly to the first embodiment, the presence of the magnetic substance can be detected due to the change in the resistances of both the magnetic resistance elements 2ab and 2cd provided with the magnetosensitive portions 20ab and 20cd.

In the example in part (A) of Fig. 5, while the magnetic resistance elements can be disposed so that, for instance as shown in part (B) of Fig. 5, three magnets (5a, 5b and 5c) and (5d, 5e and 5f) make units, respectively, in the order of arrangement, and magnetic resistance elements 20abc and 20def entirely span the units of the magnets, respectively. Alternatively, four or more magnets can make a unit. That is, a magnetic resistance element can be disposed so that at least two of the magnets make a unit, and the magnetic resistance element entirely spans at least the two magnets.

Next, a long magnetic sensor according to a third embodiment will be described below with reference to Fig. 6.

In this example, a magnetic resistance element is disposed to span the adjacent magnets, at each of positions where the magnets are adjacent to each other. In this example, the magnetic resistance element 2ab is disposed to span the magnets 5a and 5b. Then, a magnetic resistance element 2bc is disposed to span the magnets 5b and 5c. In addition, the magnets 5a, 5b and 5c are disposed so that the magnetic poles of the continuously disposed magnets are alternately inversed.

With this configuration, the center portion of the magnet is located at a position corresponding to a gap provided between the magnetosensitive portions of the two adjacent magnetic resistance elements. In an example shown in Fig. 6, the center portion of the magnet 5b is located at a position corresponding to a gap Gh provided between the magnetosensitive portions 20ab and 20bc of the magnetic resistance elements 2ab and 2cd. Since the magnetic flux density of the center portion of the magnet is high and stable as compared with that of the end portions, the magnetic flux density between the adjacent magnetosensitive portions can be higher than other region. Consequently, the degradation of the detection level at the position corresponding to the gap Gh can be compensated, and detection level characteristics which show a flat line over the longitudinal direction can be obtained. In addition, even when the borders of the adjacent magnets are unevenly disposed, since the magnetic flux density at the position corresponding to the gap Gh can be kept high, the variation in the detection level due to the unevenness can be reduced. Note that the characteristics shown between the magnets are similar to that of the second embodiment.

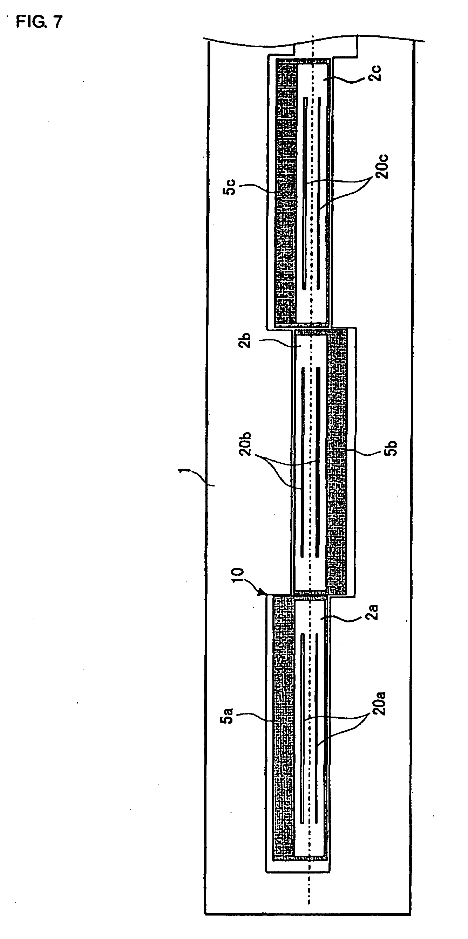

Next, a long magnetic sensor according to a fourth embodiment will be described below with reference to Fig. 7.

Fig. 7 is a plan view partially showing a plane parallel to the magnetosensitive portions of the magnetic resistance elements of the long magnetic sensor. The magnetic resistance elements 2a to 2c are linearly disposed as shown by a chain line in the drawing. The magnets 5a, 5b and 5c are disposed at the magnetic resistance elements 2a, 2b and 2c, respectively. Dissimilarly to the first embodiment, frames 10 are formed at the bottom surface of the case 1 so that the magnets are disposed along the arrangement of the magnetic resistance elements 2a to 2c in a staggered manner in a plane parallel to the magnetosensitive portions 20a, 20b and 20c of the magnetic resistance elements. Accordingly, the frames 10 serve as magnet housings disposed in a zigzag manner, so that the positions of the magnets can be easily determined relative to the case only by sequentially attaching the magnets to the frames 10. In addition, since the direction of the magnetic poles of the adjacent magnets are inverse to each other, and therefore the magnets attract to each other to be linearly disposed as shown by a chain line in the drawing, the positions of the magnets can be automatically determined also in a direction orthogonal to the chain line in the drawing.

Note that Fig. 7 shows the example in which the arrangement of the magnets relative to the case is applied to the first embodiment. However, the arrangement can be alternatively applied to the second or third embodiment in a similar manner.

The present invention can be used for absorbing vibration due to friction between moving plates.

## Claims

1. An elongated magnetic sensor for detecting a magnetic pattern (101) on a detection object (100) passing the elongated magnetic sensor along a direction being substantially orthogonal to the longitudinal direction of the elongated magnetic sensor, the elongated magnetic sensor comprising:
a plurality of magnetic resistance elements (2a-2e) which are provided with magnetosensitive portions (20a-20e) on or at surfaces of the magnetic resistance elements (2a-2e), each of the magnetosensitive portions extending along the longitudinal direction of the elongated magnetic sensor; and
a plurality of magnets (5a-5e) for applying magnetic fields to the magnetosensitive portions (20a-20e) of the magnetic resistance elements (2a-2e),
wherein the plurality of magnets (5a-5e) are provided below the magnetosensitive portions (20a-20e) of the plurality of magnetic resistance elements (2a-2e), **characterized in that**
the magnets (5a-5e) are disposed so that directions of magnetic fluxes, which are substantially perpendicular to the surfaces of the magnetic resistance elements (2a-2e) provided with the magnetosensitive portions (20a-20e), of adjacent magnets are inverse to each other.

2. The elongated magnetic sensor according to Claim 1, wherein the magnets (5a-5e) are disposed in one-to-one correspondence with the magnetic resistance elements (2a-2e).

3. The elongated magnetic sensor according to Claim 1, wherein each of the magnetic resistance elements (2a-2e) is disposed so that at least two of the plurality of magnets (5a-5e) make a unit in the order of arrangement of the magnets (5a-5e) and the magnetic resistance element (2a-2e) entirely spans at least the two magnets.

4. The elongated magnetic sensor according to Claim 1, wherein each of the magnetic resistance elements (2a-2e) is disposed to span the adjacent magnets (5a-5e) at each of positions where the plurality of magnets (5a-5e) are adjacent to each other.

5. The elongated magnetic sensor according to any one of Claims 1 to 4, further comprising a case (1) for housing the magnetic resistance elements (2a-2e) and the magnets (5a-5e), wherein frames are provided in the case (1) so that the magnets (5a-5e) are disposed along an alignment direction of the magnetic resistance elements (2a-2e) in a zigzag manner in a plane parallel to the magnetosensitive portions (20a-20e) of the magnetic resistance elements (2a-2e).

## Patentansprüche

1. Ein länglicher Magnetsensor zum Erfassen einer magnetischen Struktur (101) an einem Erfassungsobjekt (100), das den länglichen Magnetsensor entlang einer Richtung passiert, die im Wesentlichen orthogonal zur der Längsrichtung des länglichen Magnetsensors ist, wobei der längliche Magnetsensor folgende Merkmale aufweist:
eine Mehrzahl von Magnetwiderstandselementen (2a-2e), die mit magnetosensitiven Abschnitten (20a-20e) auf oder an Oberflächen der Magnetwiderstandselemente (2a-2e) versehen sind, wobei sich jeder der magnetosensitiven Abschnitte entlang der Längsrichtung des länglichen Magnetsensors erstreckt; und
eine Mehrzahl von Magneten (5a-5e) zum Anlegen von Magnetfeldern an die magnetosensitiven Abschnitte (20a-20e) der Magnetwiderstandselemente (2a-2e),
wobei die Mehrzahl von Magneten (5a-5e) unterhalb der magnetosensitiven Abschnitte (20a-20e) der Mehrzahl von Magnetwiderstandselementen (2a-2e) vorgesehen ist,
**dadurch gekennzeichnet, dass**
die Magneten (5a-5e) derart angeordnet sind, dass Richtungen von Magnetflüssen,
die im Wesentlichen senkrecht zu den Oberflächen der mit den magnetosensitiven Abschnitten (20a-20e) versehenen Oberflächen der Magnetwiderstandselemente (2a-2e) sind, benachbarter Magneten invers zueinander sind.

2. Der längliche Magnetsensor gemäß Anspruch 1, bei dem die Magneten (5a-5e) in einer Eins-zu-Eins-Entsprechung bezüglich der Magnetwiderstandselemente (2a-2e) angeordnet sind.

3. Der längliche Magnetsensor gemäß Anspruch 1, bei dem jedes der Magnetwiderstandselemente (2a-2e) derart angeordnet ist, dass zumindest zwei der Mehrzahl von Magneten (5a-5e) in der Reihenfolge der Anordnung der Magneten (5a-5e) eine Einheit bilden und das magnetische Widerstandselement (2a-2e) zumindest die zwei Magneten gänzlich umspannt.

4. Der längliche Magnetsensor gemäß Anspruch 1, bei dem jedes der Magnetwiderstandselemente (2a-2e) dahin gehend angeordnet ist, die benachbarten Magneten (5a-5e) an jeder von Positionen, wo die Mehrzahl von Magneten (5a-5e) zueinander benachbart sind, zu umspannen.

5. Der längliche Magnetsensor gemäß einem der Ansprüche 1 bis 4, der ferner ein Gehäuse (1) zum Beherbergen der Magnetwiderstandselemente (2a-2e) und der Magneten (5a-5e) aufweist, wobei Rahmen in dem Gehäuse (1) vorgesehen sind, so dass die Magneten (5a-5e) entlang einer Ausrichtungsrichtung der Magnetwiderstandselemente (2a-2e) im Zickzack in einer Ebene angeordnet sind, die zu den magnetosensitiven Abschnitten (20a-20e) der Magnetwiderstandselemente (2a-2e) parallel ist.

## Revendications

1. Capteur magnétique allongé pour détecter un modèle magnétique (101) sur un objet de détection (100) passant le capteur magnétique allongé le long d'une direction qui est sensiblement orthogonale à la direction longitudinale du capteur magnétique allongé, le capteur magnétique allongé comprenant :
une pluralité d'éléments magnétorésistifs (2a-2e) qui sont prévus avec des parties magnétosensibles (20a-20e) sur ou au niveau des surfaces des éléments magnétorésistifs (2a-2e), chacune des parties magnétosensibles s'étendant le long de la direction longitudinale du capteur magnétique allongé ; et
une pluralité d'aimants (5a-5e) pour appliquer des champs magnétiques sur les parties magnétosensibles (20a-20e) des éléments magnétorésistifs (2a-2e),
dans lequel la pluralité d'aimants (5a-5e) sont prévus au-dessous des parties magnétosensibles (20a-20e) de la pluralité d'éléments magnétorésistifs (2a-2e), **caractérisé en ce que**
les aimants (5a-5e) sont disposés de sorte que les directions des flux magnétiques, qui sont sensiblement perpendiculaires aux surfaces des éléments magnétorésistifs (2a-2e) prévus avec les parties magnétosensibles (20a-20e), des aimants adjacents sont opposées les unes par rapport aux autres.

2. Capteur magnétique allongé selon la revendication 1, dans lequel les aimants (5a-5e) sont disposés selon une correspondance un à un avec les éléments magnétorésistifs (2a-2e).

3. Capteur magnétique allongé selon la revendication 1, dans lequel chacun des éléments magnétorésistifs (2a-2e) est disposé de sorte qu'au moins deux de la pluralité d'aimants (5a-5e) réalisent une unité dans l'ordre d'agencement des aimants (5a-5e) et l'élément magnétorésistif (2a-2e) couvre entièrement au moins les deux aimants.

4. Capteur magnétique allongé selon la revendication 1, dans lequel chacun des éléments magnétorésistifs (2a-2e) est disposé pour couvrir les aimants (5a-5e) adjacents dans chacune des positions dans lesquelles la pluralité d'aimants (5a-5e) sont adjacents les uns par rapport aux autres.

5. Capteur magnétique allongé selon l'une quelconque des revendications 1 à 4, comprenant en outre un boîtier (1) pour loger les éléments magnétorésistifs (2a-2e) et les aimants (5a-5e), dans lequel des châssis sont prévus dans le boîtier (1) de sorte que les aimants (5a-5e) sont disposés le long d'une direction d'alignement des éléments magnétorésistifs (2a-2e) en zigzag dans un plan parallèle aux parties magnétosensibles (20a-20e) des éléments magnétorésistifs (2a-2e).
